# EUROPEAN PATENT SPECIFICATION

(11) **EP 2 492 331 B1**
(45) Date of publication and mention of the grant of the patent: **12.07.2017**
(21) Application number: 10824860.0
(22) Date of filing: 15.10.2010
(51) Int. Cl.: C09J 163/02, C09J 4/02, C09J 7/02, C09J 11/00, C09J 179/08, H01L 21/52

(54) **PHOTOSENSITIVE ADHESIVE COMPOSITION, PHOTOSENSITIVE ADHESIVE SHEET, AND SEMICONDUCTOR DEVICES USING SAME**
LICHTEMPFINDLICHE HAFTZUSAMMENSETZUNG, LICHTEMPFINDLICHER HAFTSTOFF UND HALBLEITERBAUELEMENTE DAMIT
COMPOSITION ADHÉSIVE PHOTOSENSIBLE, FEUILLE ADHÉSIVE PHOTOSENSIBLE, ET DISPOSITIFS SEMI-CONDUCTEURS UTILISANT CELLES-CI

(30) Priority: 19.10.2009 JP 2009240162
(43) Date of publication of application: 29.08.2012
(73) Proprietor: Toray Industries, Inc., Tokyo 103-8666 (JP)
(72) Inventor: SHIMADA, Akira, Otsu-shi Shiga 520-8558 (JP); TACHIBANA, Yasuko, Otsu-shi Shiga 520-8558 (JP); NIWA, Hiroyuki, Otsu-shi Shiga 520-8558 (JP); NONAKA, Toshihisa, Otsu-shi Shiga 520-8558 (JP)
(74) Representative: Hoefer & Partner Patentanwälte mbB
(86) International application number: PCT/JP2010/068133
(87) International publication number: WO 2011/049011

(56) References cited:
- EP-A1- 0 361 415
- WO-A1-2008/123110
- WO-A1-2008/123507
- WO-A1-2008/149625
- JP-A- 2002 278 143
- JP-A- 2005 290 215
- JP-A- 2008 133 423
- JP-A- 2009 021 562
- JP-A- 2009 164 574
- JP-A- 2009 194 054
- JP-A- 2009 221 453

## Description

### Technical Field

The present invention relates to a photosensitive adhesive composition, a photosensitive adhesive sheet, and a semiconductor device using the same.

### Background Art

With recent requirements for high performances of electronic components, miniaturization of semiconductor devices as well as an increase in working speed and density of wirings have been making progress, and various package forms coping therewith have been proposed. For example, there is proposed a semiconductor package having a three-dimensional structure in which semiconductor chips are provided with through electrodes and electrode structures such as pads and bumps connected electrically to the through electrodes are provided on both front and rear surfaces of semiconductor chips, and then continuity between chips is ensured by laminating these semiconductor chips. In the package having such a structure, an adhesive is usually used in case of laminating chips. Low stress, adhesive properties, insulation stability and solder reflow resistance are required to the adhesive used herein. In addition, it is effective that patterning can be performed by light, that is, the adhesive has photosensitivity so as to endure continuity between chips by removing only the relevant portion of the adhesive, which has covered electrodes in the step of forming an adhesive coating film on semiconductor chips, thereby exposing the electrodes.

There is also known a method in which an element is surrounded with a resin spacer having adhesive properties and a substrate such as glass is affixed to a top surface to form a hollow structure so as to form a hollow package such as an image sensor or MEMS (see Patent Document 1). An adhesive having both various mounting reliabilities and photosensitivity is also required in this application.

Materials containing a polyimide resin precursor as a base are proposed as an adhesive having a photosensitive function (see Patent Document 2). However, these materials must be thermally cured at a high temperature of 300° or higher for an imide ring-closing reaction and therefore had a problem that thermal stress at the time of cooling increases and causes large damage against peripheral members. In order to cope with these problems, there are proposed materials which contain a soluble polyimide as a base resin thereby reducing a curing temperature (see Patent Documents 3 to 5).

### Prior Art Documents

### Patent Documents

Patent Document 1: Japanese Unexamined Patent Publication (Kokai) No. 2008-286877
Patent Document 2: Japanese Unexamined Patent Publication (Kokai) No. 04-337380
Patent Document 3: Japanese Unexamined Patent Publication (Kokai) No. 2008-281597
Patent Document 4: Japanese Unexamined Patent Publication (Kokai) No. 2008-88403
Patent Document 5: Japanese Unexamined Patent Publication (Kokai) No. 2009-221453

US2011223397 discloses a photosensitive adhesive composition comprising a polyimide resin and an epoxy resin.

### Disclosure of the Invention

### Problems to be Solved by the Invention

However, in resin design described in Patent Document 3, thermocompression bondability to a substrate such as a silicon wafer or a glass substrate was sometimes insufficient because of large thermal stress of a soluble polyimide. As described in Patent Documents 4 and 5, when a skeleton having high flexibility, like aliphatic ether diamine is introduced, there were a problem that solubility of polyimide in an alkali developing solution decreases, resulting in poor resolution at the time of development, and a problem that an adhesive strength decreases since a cross-link density decreases. In polyimide having a carboxylic acid group, solubility in an alkali developing solution is improved. However, there was a problem that polarity of a resin increases and thus hydrophilicity increases, resulting in poor insulation stability.

An object of the present invention is to provide a photosensitive adhesive composition which can be developed with an alkali developing solution after exposure, and exhibits high adhesive strength in case of thermocompression bonding on a substrate, and is also excellent in insulation stability.

### Means for Solving the Problems

The present invention is directed to a photosensitive adhesive composition including:
(A) an epoxy compound,
(B) a soluble polyimide,
(C) a photopolymerizable compound, and
(D) a photopolymerization initiator, wherein the epoxy compound (A) contains an epoxy compound represented by the general formula (1), and also the soluble polyimide (B) has a residue of the diamine represented by the general formula (2).

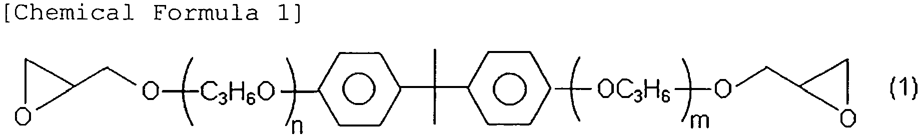

In the above general formula (1), m and n are integers of 0 or more, which satisfy the relationship: 1 ≤ ≤ 10.

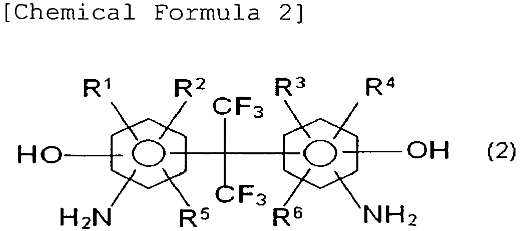

In the above general formula (2), R¹ to R⁶ may be respectively the same or different and are selected from the group consisting of a hydrogen atom, an alkyl group having 1 to 30 carbon atoms, an alkoxy group having 1 to 30 carbon atoms, a halogen, a sulfone group, a nitro group and a cyano group.

The present invention also includes a photosensitive adhesive sheet including a support, and a coating film made of the above photosensitive adhesive composition formed on the support.

The present invention also includes a semiconductor device including a plurality of substrates or a substrate and other members, which are bonded to each other through a cured product of the above photosensitive adhesive composition.

### Effects of the Invention

According to the present invention, it is possible to obtain a photosensitive adhesive composition which can be developed with an alkali developing solution after exposure, and exhibits high adhesive strength in case of thermocompression bonding on a substrate, and is also excellent in insulation stability.

### Mode for Carrying Out the Invention

The photosensitive adhesive composition in the present invention means a composition which can form a pattern by photolithography, and also can be bonded to other members by thermocompression bonding. There is no limitation on the shape of the photosensitive adhesive composition before curing, and examples of the shape include liquid, film, sheet applied on the support and the like.

The photosensitive adhesive composition of the present invention contains an epoxy compound (A), a soluble polyimide (B), a photopolymerizable compound (C) and a photopolymerization initiator (D).

The epoxy compound (A) contains an epoxy compound represented by the general formula (1).

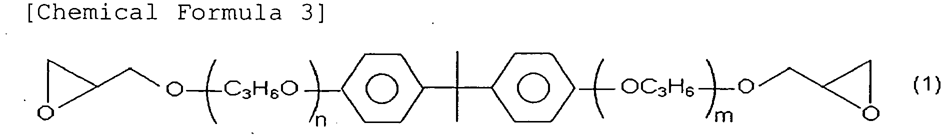

In the above general formula (1), m and n are integers of 0 or more, which satisfy the relationship: 1 ≤ m + n ≤ 10.

The epoxy compound represented by the general formula (1) is a compound which has two epoxy groups in the molecule, and includes one or more propylene oxide (-C₃H₆O-) units. Examples of the epoxy compound include "ADEKA RESIN (registered trademark)" EP-4000S, EP-4003S (manufactured by ADEKA Corporation) and the like.

The epoxy compound represented by the general formula (1) can improve the cross-link density after curing of a photosensitive adhesive composition and also can improve the adhesive strength by use of an epoxy group. The epoxy compound also has the effect capable of increasing the rate of dissolution of a photosensitive adhesive composition in an aqueous alkali solution, and also capable of improving the resolution at the time of development, since a propylene oxide unit included has moderate hydrophilicity. Furthermore, hydrophilicity of an epoxy compound is increased by adjusting the number of repeating units of propylene oxide (m + n) to 1 or more, and more preferably 3 or more, and thus developability of a photosensitive adhesive composition in an aqueous alkali solution becomes satisfactory. In contrast, in case of using an epoxy compound including no propylene oxide unit (a compound of the general formula (1) in which m = n = 0), developability of a photosensitive adhesive composition deteriorates and thus development takes much more time and resolution becomes worse, unfavorably. When the number of repeating units of propylene oxide is too large, the cross-link density decreases, leading to the decrease in adhesive strength. Therefore, (m + n) is preferably adjusted to 10 or less, and more preferably 7 or less. As described above, the number of repeating units of propylene oxide (m + n), is preferably adjusted to 1 or more and 10 or less, and more preferably 3 or more and 7 or less, so as to compatibilize the developability with the adhesive strength.

The content of the epoxy compound (A) is desirably 15% by weight or more and 50% by weight or less based on the total amount of components (A) to (C). When the content of the epoxy compound is adjusted to 15% by weight or more, and more preferably 20% by weight or more, in case of performing thermocompression bonding of the photosensitive adhesive composition coating film after development and the substrate, the viscosity of the composition decreases and thus a thermal flow amount increases and tight adhesion to a substrate with a step is also improved. Herein, the thermal flow amount means a parameter which indicates, to what extent, can a photosensitive adhesive composition flow when the photosensitive adhesive composition is heated and pressurized. The measuring method will be described in detail hereinafter. From the viewpoint of heat resistance and developability, the content of the epoxy compound (A) is preferably 50% by weight or less, and more preferably 40% by weight or less, based on the total amount of components (A) to (C).

The photosensitive adhesive composition of the present invention may contain one or more kinds of epoxy compounds other than those of the general formula (1). In this case, the content of the epoxy compound (A) is calculated, assuming that the total content of an epoxy compound represented by the general formula (1) and an epoxy compound other than that of the general formula (1) is the content of the component (A), and the content of the epoxy compound is preferably within the above range. In case of containing the epoxy compound other than that of the general formula (1), the content of the epoxy compound represented by the general formula (1) is preferably from 30 to 99% by weight, and more preferably from 50 to 99% by weight, in the entire epoxy compound.

There is no particular limitation on the epoxy compound other than that of the general formula (1), and examples thereof include bisphenol A type epoxy compounds manufactured by Yuka Shell Epoxy Co. Ltd under the of trade name of EPIKOTE 828, 834, 1001, 1002, 1003, 1004, 1005, 1007, 1010 and 1100L; o-cresol novolak type epoxy compounds manufactured by Yuka Shell Epoxy Co. Ltd under the of trade name of EPIKOTE ESCN-220L, 220F, 220H, 220HH and 180H65; novolak type epoxy compounds manufactured by Yuka Shell Epoxy Co. Ltd. under the trade name of EPIKOTE 1032H60, and those manufactured by NIPPON KAYAKU CO., LTD. under the trade name of EPPN-502H; naphthalene aralkyl novolak type epoxy compounds manufactured by Nippon Steel Chemical Co., Ltd. under the trade name of SN-375 and ESN-185; and biphenol type epoxy compounds manufactured by Yuka Shell Epoxy Co. Ltd under the of trade name of X4000H. It is also possible to exemplify, in addition to the above compounds, bisphenol A glycidyl ether type epoxy compounds, bisphenol F glycidyl ether type epoxy compounds, novolak glycidyl ether type epoxy compounds, glycidyl ester type epoxy compounds, glycidyl amine type epoxy compounds, cyclic aliphatic epoxy compounds and aromatic epoxy compounds.

The soluble polyimide (B) in the present invention means a soluble polyimide which dissolves in 100 g of any organic solvent (at 25°C) of amide-based solvents such as N-methyl-2-pyrrolidone, N,N-dimethylacetamide, N,N-dimethylformamide, N-vinyl pyrrolidone and N,N-diethylformamide; γ-butyrolactone; and ether-based solvents such as methyl monoglyme, methyl diglyme, methyl triglyme, ethyl monoglyme, ethyl diglyme, ethylene glycol monomethyl ether, ethylene glycol monoethyl ether, propylene glycol monomethyl ether, propylene glycol monoethyl ether, ethylene glycol dimethyl ether and ethylene glycol diethyl ether, in the amount of 1 g or more.

The soluble polyimide (B) is preferably alkali soluble. The alkali soluble polyimide means an alkali soluble polyimdie which dissolves in 100 g of an aqueous 2.38% solution of tetramethylammonium hydroxide at 25°C in the amount of 1 g or more.

The soluble polyimide (B) is obtained by a reaction of tetracarboxylic dianhydride with diamine, and has a residue of tetracarboxylic dianhydride and a residue of diamine. In the present invention, the residue of tetracarboxylic dianhydride and the residue of diamine preferably have a structure which (1) includes less benzene ring, (2) has a large molecular weight and is bulky, and also (3) has a lot of bent portions such as an ether bond. The interaction between molecular chains is decreased by such a structure, and thus solubility of the soluble polyimide in an organic solvent is improved. It is desired that the soluble polyimide (B) has an alkali-soluble functional group so as to develop with an aqueous alkali solution. The alkali-soluble functional group is an acidic functional group, and specific examples thereof include a phenolic hydroxyl group, a carboxyl group and the like. From the viewpoint of obtaining high insulation stability after curing, it is preferred to contain a hydroxyl group having low polarity.

As described above, the soluble polyimide (B) has a diamine residue represented by the general formula (2) in the present invention.

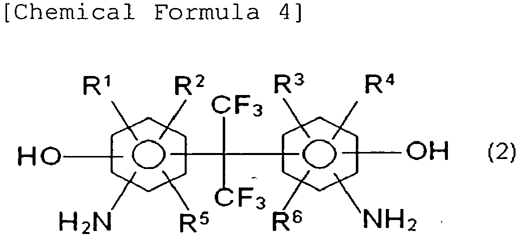

In the above general formula (2), R¹ to R⁸ may be respectively the same or different and are selected from the group consisting of a hydrogen atom, an alkyl group having 1 to 30 carbon atoms, an alkoxy group having 1 to 30 carbon atoms, a halogen, a sulfone group, a nitro group and a cyano group. From the viewpoint of organic solvent solubility of polyimide, and alkali solubility, R¹ to R⁸ are preferably selected from a hydrogen atom and a sulfone group.

Since a hexafluoroisopropylidene group has a large molecular weight and is bulky, cohesive energy of polyimide decreases, resulting in decreased surface tension of a photosensitive adhesive composition. Whereby, it becomes easy to remove a support after affixing the photosensitive adhesive composition applied on the support by lamination on a silicon wafer, and thus bondability to a silicon wafer is improved. From the viewpoint of improving the bondability to a silicon wafer, it is preferred to have 20 mol% or more of a residue of the diamine represented by the general formula (2) in the entire diamine residue. From the viewpoint of the flexibility and adhesive properties, the content of the residue is preferably 95 mol% or less.

The soluble polyimide (B) may have a residue of diamine represented by the following general formula (5).

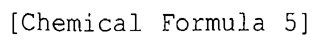

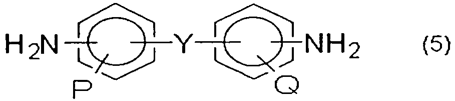

In the general formula (5), Y represents -CO-, -SO₂-, -O-, -S-, -CH₂-, -NHCO-, -C(CH₃)₂-, -COO- or a single bond, and P and Q respectively represent a hydroxyl group or a carboxyl group.

Examples of the diamine compound represented by the general formula (5) include diamine compounds having a phenolic hydroxyl group in the molecule, for example, hydroxybiphenyl compounds such as 3,3'-diamino-4,4'-dihydroxybiphenyl, 4,4'-diamino-3,3'-dihydroxybiphenyl and 4,4'-diamino-2,2'-dihydroxybiphenyl; hydroxydiphenylalkane compounds such as 3,3'-diamino-4,4'-dihydroxydiphenylmethane, 4,4'-diamino-3,3'-dihydroxydiphenylmethane, 4,4'-diamino-2,2'-dihydroxydiphenylmethane, 2,2-bis[3-amino-4-hydroxyphenyl]propane, 2,2-bis[4-amino-3-hydroxyphenyl]propane and 2,2-bis[3-amino-4-hydroxyphenyl]hexafluoropropane; hydroxydiphenylether compounds such as 3,3'-diamino-4,4'-dihydroxydiphenylether, 4,4'-diamino-3,3'-dihydroxydiphenylether and 4,4'-diamino-2,2'-dihydroxydiphenylether; hydroxydiphenylsulfone compounds such as 3,3'-diamino-4,4'-dihydroxydiphenylsulfone, 4,4'-diamino-3,3'-dihydroxydiphenylsulfone and 4,4'-diamino-2,2'-dihydroxydiphenylsulfone; and the like; or diamine compounds having a carboxyl group in the molecule, such as 3,3'-dicarboxy-4,4'-diaminodiphenylmethane.

In case of having a residue of the diamine represented by the general formula (5), the total content of a residue of the diamine represented by the general formula (2) and a residue of the diamine represented by the general formula (5) is preferably 95 mol% or less in the entire diamine residue, from the viewpoint of increasing the chemical resistance after curing and preventing deterioration of the reliability due to water absorption.

It is preferred that the soluble polyimide (B) further has, as a diamine residue, a residue of diamine represented by the general formula (4) from the viewpoint of improving thermocompression bondability by lowering a glass transition temperature.

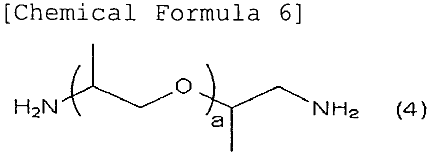

"a" in the general formula (4) is within a range from 2 to 10. When "a" is 2 or more, the effect of softening due to an ether bond is improved, and thus the glass transition temperature can be lowered, resulting in improved thermocompression bondability. In contrast, when a" is 10 or less, the resolution is improved without exerting an adverse influence on development. In addition, when "a" is within the above range, a molecular chain length between imide groups falls within an appropriate range. Therefore, the regularity of the molecular chain is improved and thus chemical resistance and heat resistance after curing can be enhanced. From the viewpoint of obtaining high resolution, "a" is more preferably 4 or less. From the viewpoint of preventing peeling of the exposed portion in case of developing with an aqueous alkali solution and preventing the adhesive strength from decreasing without causing drastic deterioration of orientation properties of a resin, the content of the residue of diamine represented by the general formula (4) is preferably 50 mol% or less, and more preferably 40 mol% or less, in the entire diamine residue.

The soluble polyimide (B) may have, in addition to the above diamine residues, other diamine residues as long as the effects of the present invention are not impaired. Examples of the residue include residues of diamine compounds, for example, diamines having one benzene ring, such as 1,4-diaminobenzene, 1,3-diaminobenzene, 2,4-diaminotoluene and 1,4-diamino-2,5-dihalogenobenzene; diamine having two benzene rings, such as bis(4-aminophenyl)ether, bis(3-aminophenyl)ether, bis(4-aminophenyl)sulfone, bis(3-aminophenyl)sulfone, bis(4-aminophenyl)methane, bis(3-aminophenyl)methane, bis(4-aminophenyl)sulfide, bis(3-aminophenyl)sulfide, 2,2-bis(4-aminophenyl)propane, 2,2-bis(3-aminophenyl)propane, 2,2-bis(4-aminophenyl)hexafluoropropane, o-dianisidine, o-tolidine and tolidinesulfonic acid; diamine having three benzene rings, such as 1,4-bis(4-aminophenoxy)benzene, 1,4-bis(3-aminophenoxy)benzene, 1,4-bis(4-aminophenyl)benzene, 1,4-bis(3-aminophenyl)benzene, α,α'-bis(4-aminophenyl)-1,4-diisopropylbenzene and α,α'-bis(4-aminophenyl)-1,3-diisopropylbenzene; diamines having four benzene rings such as 2,2-bis[4-(4-aminophenoxy)phenyl]propane, 2,2-bis[4-(4-aminophenoxy)phenyl]hexafluoropropane, 2,2-bis[4-(4-aminophenoxy)phenyl]sulfone, 4,4'-(4-aminophenoxy)biphenyl, 9,9-bis(4-aminophenyl)fluorene and 5,10-bis(4-aminophenyl)anthracene; and the like.

It is preferred that the soluble polyimide (B) has a residue of an acid anhydride represented by the general formula (3).

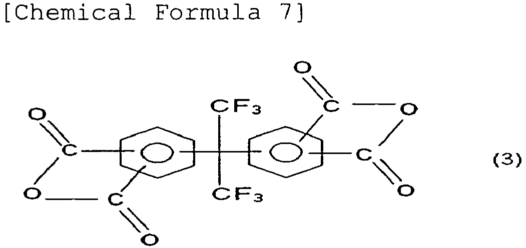

Since a hexafluoroisopropylidene group has a large molecular weight and is bulky, cohesive energy of a soluble polyimide decreases, resulting in decreased surface tension of a photosensitive adhesive composition. Whereby, it becomes easy to remove a support after affixing the photosensitive adhesive composition applied on the support by lamination on a silicon wafer, and thus bondability to a silicon wafer is improved. From the viewpoint of improving the bondability to a silicon wafer, it is preferred to have 20 mol% or more of a residue of the acid anhydride represented by the above general formula (3) in the entire diamine residue. From the viewpoint of the flexibility and adhesive properties, the content of the residue is preferably 95 mol% or less.

The soluble polyimide (B) may have, in addition to the above acid dianhydride residues, other acid dianhydride residues as long as the effects of the present invention are not impaired. Examples of the other acid dianhydrides include pyromellitic anhydride (PMDA), oxydiphthalic dianhydride (ODPA), 3,3',4,4'-benzophenonetetracarboxylic dianhydride (BTDA), 3,3',4,4'-biphenyltetracarboxylic dianhydride (BPDA), 3,3',4,4'-diphenylsulfonetetracarboxylic dianhydride (DSDA), 2,2'-bis[(dicarboxyphenoxy)phenyl]propane dianhydride (BSAA) and the like.

It is preferred that at least a portion of the terminal of the soluble polyimide (B) is blocked with an aniline derivative or dicarboxylic anhydride. Whereby, it is possible to easily adjust the weight average molecular weight of the soluble polyimide within an appropriate range. It is expected to suppress an increase in viscosity due to cross-linking of a terminal functional group. The aniline derivative is preferably 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid, 3-aminobenzenesulfonic acid, 4-aminobenzenesulfonic acid, 2-aminophenol, 3-aminophenol, 4-aminophenol, 2-aminothiophenol, 3-aminothiophenol, 4-aminothiophenol or the like. It is possible to preferably use, as the dicarboxylic anhydride, maleic anhydride, phthalic anhydride, nadic anhydrideanhydride, cyclohexanedicarboxylic anhydride, 5-norbornene-2,3-dicarboxylic anhydride, 1,2-dicarboxynaphthalene anhydride, 3-hydroxyphthalic anhydride and the like.

The weight average molecular weight of the soluble polyimide (B) is preferably 10,000 or more and 100,000 or less. In case of containing two or more kinds of soluble polyimides, the weight average molecular weight of at least one kind among them may be within the above range. When the weight average molecular weight is less than 10,000, the mechanical strength may sometimes decrease, resulting in decreased adhesive strength. The weight average molecular weight is preferably 12,000 or more. In contrast, when the weight average molecular weight is more than 100,000, the developability with an aqueous alkali solution may sometimes deteriorate, resulting in generation of development residue. The weight average molecular weight is preferably 50,000 or less. The weight average molecular weight in the present invention is determined by measuring using a gel permeation chromatographic method (GPC method) and calculating in terms of polystyrene.

The photosensitive adhesive composition of the present invention may contain a soluble polyimide which does not contain diamine of the general formula (2). In this case, the total content of the entire soluble polyimide is calculated as the content of the component (B). In case of containing other soluble polyimides, the content of the soluble polyimide containing diamine of the general formula (2) is preferably from 30 to 99% by weight, and more preferably from 50 to 99% by weight, in the entire soluble polyimide.

There is no particular limitation on the method for the synthesis of a soluble polyimide (B), and the soluble polyimide can be synthesized by a known method using diamine and tetracarboxylic dianhydride. For example, a polyimide precursor is obtained by employing a method in which tetracarboxylic dianhydride and a diamine compound (may be partially substituted on an aniline derivative) are reacted at a low temperature; a method in which a diester is obtained by a reaction of tetracarboxylic dianhydride with an alcohol, and then the obtained diester is reacted with diamine (may be partially substituted on an aniline derivative) in the presence of a condensing agent; or a method in which a diester is obtained by a reaction of tetracarboxylic dianhydride with an alcohol, and then remaining two carboxyl groups are subjected to acid chlorination and reacted with diamine (may be partially substituted on an aniline derivative); and then a soluble polyimide can be synthesized from the polyimide precursor by employing a known imidation method.

The photosensitive adhesive composition of the present invention contains a photopolymerizable compound (C) and a photopolymerization initiator (D). The photopolymerizable compound (C) is preferably a compound having at least one unsaturated double bond in the molecule. Examples thereof include a compound having a group selected from a vinyl group, an acryloyl group and a methacryloyl group.

Examples of the photopolymerizable compound (C) include diethylene glycol diacrylate, triethylene glycol diacrylate, tetraethylene glycol diacrylate, diethylene glycol dimethacrylate, triethylene glycol dimethacrylate, tetraethylene glycol dimethacrylate, trimethylolpropane diacrylate, trimethylolpropane triacrylate, trimethylolpropane dimethacrylate, trimethylolpropane trimethacrylate, styrene, α-methylstyrene, 1,2-dihydronaphthalene, 1,3-diisopropenylbenzene, 3-methylstyrene, 4-methylstyrene, 2-vinylnaphthalene, butyl acrylate, butyl methacrylate, isobutyl acrylate, hexyl acrylate, isooctyl acrylate, isobornyl acrylate, isobornyl methacrylate, cyclohexyl methacrylate, 1,3-butanediol diacrylate, 1,3-butanediol dimethacrylate, neopentyl glycol diacrylate, 1,4-butanediol diacrylate, 1,4-butanediol dimethacrylate, 1,6-hexanediol diacrylate, 1,6-hexanediol dimethacrylate, 1,9-nonanediol dimethacrylate, 1,10-decanediol dimethacrylate, dimethylol-tricyclodecane diacrylate, pentaerythritol triacrylate, pentaerythritol tetraacrylate, pentaerythritol trimethacrylate, pentaerythritol tetramethacrylate, dipentaerythritol hexaacrylate, dipentaerythritol hexamethacrylate, 2-hydroxyethyl acrylate, 2-hydroxyethyl methacrylate, 1,3-diacryloyloxy-2-hydroxypropane, 1,3-dimethacryloyloxy-2-hydroxypropane, methylenebisacrylamide, N,N-dimethylacrylamide, N-methylolacrylamide, 2,2,6,6-tetramethylpiperidinyl methacrylate, 2,2,6,6-tetramethylpiperidinyl acrylate, N-methyl-2,2,6,6-tetramethylpiperidinyl methacrylate, N-methyl-2,2,6,6-tetramethylpiperidinyl acrylate, ethylene oxide-modified bisphenol A diacrylate, ethylene oxide-modified bisphenol A dimethacrylate, propylene oxide-modified bisphenol A diacrylate, propylene oxide-modified bisphenol A methacrylate, propoxylated-ethoxylated bisphenol A diacrylate, propoxylated-ethoxylated bisphenol A dimethacrylate, N-vinyl pyrrolidone, N-vinyl caprolactam and the like. These compounds can be used alone, or two or more kinds of them can be used in combination.

Among these compounds, particularly preferred compounds include 1,9-nonanediol dimethacrylate, 1,10-decanediol dimethacrylate, dimethylol-tricyclodecane diacrylate, isobornyl acrylate, isobornyl methacrylate, pentaerythritol triacrylate, pentaerythritol tetraacrylate, pentaerythritol trimethacrylate, pentaerythritol tetramethacrylate, dipentaerythritol hexaacrylate, dipentaerythritol hexamethacrylate, methylenebisacrylamide, N,N-dimethylacrylamide, N-methylolacrylamide, 2,2,6,6-tetramethylpiperidinyl methacrylate, 2,2,6,6-tetramethylpiperidinyl acrylate, N-methyl-2,2,6,6-tetramethylpiperidinyl methacrylate, N-methyl-2,2,6,6-tetramethylpiperidinyl acrylate, ethylene oxide-modified bisphenol A diacrylate, ethylene oxide-modified bisphenol A dimethacrylate, propylene oxide-modified bisphenol A diacrylate, propylene oxide-modified bisphenol A methacrylate, propoxylated-ethoxylated bisphenol A diacrylate, propoxylated-ethoxylated bisphenol A dimethacrylate, N-vinyl pyrrolidone, N-vinylcaprolactam and the like.

From the viewpoint of obtaining a sufficient residual film after development, the content of the photopolymerizable compound (C) in the photosensitive adhesive composition is preferably 20 parts by weight or more, and more preferably 40 parts by weight or more, based on 100 parts by weight of the soluble polyimide (B). From the viewpoint of improving heat resistance of a cured film, the content of the photopolymerizable compound (C) is preferably 150 parts by weight or less, and more preferably 100 parts by weight or less.

Examples of the photopolymerization initiator (D) include benzophenone compounds such as benzophenone, Michler's ketone, 4,4,-bis(diethylamino)benzophenone and 3,3,4,4,-tetra(t-butylperoxycarbonyl)benzophenone; benzylidene compounds such as 3,5-bis(diethylaminobenzylidene)-N-methyl-4-piperidone and 3,5-bis(diethylaminobenzylidene)-N-ethyl-4-piperidone; cumarin compounds such as 7-diethylamino-3-nonylcumarin, 4,6-dimethyl-3-ethylaminocumarin, 3,3-carbonylbis(7-diethylaminocumarin), 7-diethylamino-3-(1-methylmethylbenzoimidazolyl)cumarin and 3-(2-benzothiazolyl)-7-diethylaminocumarin; anthraquinone compounds such as 2-t-butylanthraquinone, 2-ethylanthraquinone and 1,2-benzanthraquinone; benzoin compounds such as benzoin methyl ether and benzoin ethyl ether, benzoin isopropyl ether; thioxanthone compounds such as 2,4-dimethylthioxanthone, 2,4-diethylthioxanthone, 2,4-diisopropylthioxanthone and 2-isopropylthioxanthone; mercapto compounds such as ethylene glycol di(3-mercaptopropionate), 2-mercaptobenzthiazole, 2-mercaptobenzoxazole and 2-mercaptobenzimidazole; glycine compounds such as N-phenylglycine, N-methyl-N-phenylglycine, N-ethyl-N-(p-chlorophenyl)glycine and N-(4-cyanophenyl)glycine; oxime compounds such as 1-phenyl-1,2-butanedion-2-(o-methoxycarbonyl)oxime, 1-phenyl-1,2-propanedion-2-(o-methoxycarbonyl)oxime, 1-phenyl-1,2-propanedion-2-(o-ethoxycarbonyl)oxime, 1-phenyl-1,2-propanedion-2-(o-benzoyl)oxime, bis(α-isonitrosopropiophenone oxime)isophthal and 1,2-octanedion-1-[4-(phenylthio)phenyl]-2-(o-benzoyloxime); α-aminoalkylphenone compounds such as 2-benzyl-2-dimethylamino-1-(4-morpholinophenyl)-butan-1-one and 2-methyl-1[4-(methylthio)phenyl]-2-morpholinopropan-1-one; 2,2'-bis(o-chlorophenyl)-4,4',5,5'-tetraphenylbiimidazole; and the like. Among these compounds, a compound selected from the above benzophenone compounds, glycine compounds, mercapto compounds, oxime compounds, α-aminoalkylphenone compounds and 2,2'-bis(o-chlorophenyl)-4,4',5,5'-tetraphenylbiimidazole is suitable from the viewpoint of photoreaction. These photopolymerization initiators are used alone, or two or more kinds of them are used in combination. The photopolymerization initiator is more preferably an oxime compound, and particularly preferably a compound selected from 1-phenyl-1,2-propanedion-2-(o-ethoxycarbonyl)oxime, 1-phenyl-1,2-propanedion-2-(o-benzoyl)oxime, bis(α-isonitrosopropiophenone oxime)isophthal, OXE01, OXE02 (trade name, manufactured by Ciba Specialty Chemicals Inc.) and NCI-831 (trade name, manufactured by ADEKA Corporation).

The content of the photopolymerization initiator (D) is preferably from 0.1 to 40 parts by weight based on 100 parts by weight of the soluble polyimide (B). When two or more kinds of photopolymerization initiators are used in combination, the total amount is preferably within the above range. When the content of the photopolymerization initiator (D) is 0.1 part by weight or more, a polymerization reaction of a polymerizable compound at the time of exposure sufficiently proceeds. In contrast, when the content is 40 parts by weight or less, sufficient light transmittance ratio can be maintained even in case of a thick film, and thus a pattern can be formed. The content of the photopolymerization initiator (D) is appropriately selected within the above range, depending on the kind of the photopolymerization initiator to be selected.

Furthermore, the photosensitive adhesive composition may optionally contain a surfactant for the purpose of improving tight adhesion between the photosensitive adhesive composition and the substrate. The photosensitive adhesive composition can also contain inorganic particles such as silicon dioxide and titanium dioxide, powders of polyimide or the like. The photosensitive adhesive composition may also contain a silane coupling agent, a titanium chelating agent or the like so as to enhance adhesion with the substrate such as a silicon wafer.

Furthermore, the photosensitive resin composition can optionally contain additives such as a cross-linking agent, a cross-linking accelerator, a sensitizer, a dissolution modifier, a stabilizer and a defoamer.

The photosensitive adhesive sheet of the present invention is obtained by forming a coating film of a photosensitive adhesive composition on a support. There is no particular limitation on the support, and it is possible to use commercially available various films such as a polyethylene terephthalate (PET) film, a polyphenylene sulfide film and a polyimide film. The surface of bonding between the support and the photosensitive adhesive composition coating film may be subjected to a surface treatment with silicone, a silane coupling agent, an aluminum chelating agent, polyurea or the like so as to improve tight adhesion and releasability. There is no particular limitation on the thickness of the support, and the thickness is preferably within a range from 10 to 100 µm from the viewpoint of workability.

In addition, the photosensitive adhesive sheet may include a protective film on a photosensitive adhesive composition coating film so as to protect a surface. Whereby, it is possible to protect the surface of the photosensitive adhesive sheet from pollutants such as dirt and dust in air.

Examples of the protective film include a polyethylene film, a polypropylene (PP) film, a polyester film and the like. The protective film is preferably a protective film having small adhesive strength with the photosensitive adhesive composition coating film.

Next, the method for producing a photosensitive adhesive sheet of the present invention will be described below. The photosensitive adhesive sheet of the present invention can be obtained by applying a photosensitive adhesive composition varnish on a support, and then optionally drying the photosensitive adhesive composition varnish. The photosensitive resin composition varnish can be obtained by adding an organic solvent to a photosensitive resin composition. The photosensitive resin composition containing an organic solvent used in the production process can be used as a photosensitive resin composition varnish as it is. The organic solvent may be any organic solvent which dissolves the photosensitive resin composition.

Specific examples of the organic solvent include ethers such as ethylene glycol monomethyl ether, ethylene glycol monoethyl ether, propylene glycol monomethyl ether, propylene glycol monoethyl ether, ethylene glycol dimethyl ether, ethylene glycol diethyl ether and ethylene glycol dibutyl ether; acetates such as ethylene glycol monoethyl ether acetate, propylene glycol monomethyl ether acetate, propyl acetate, butyl acetate, isobutyl acetate, 3-methoxybutyl acetate, 3-methyl-3-methoxybutyl acetate, methyl lactate, ethyl lactate and butyl lactate; ketones such as acetone, methyl ethyl ketone, acetylacetone, methyl propyl ketone, methyl butyl ketone, methyl isobutyl ketone, cyclopentanone and 2-heptanone; alcohols such as butyl alcohol, isobutyl alcohol, pentanol, 4-methyl-2-pentanol, 3-methyl-2-butanol, 3-methyl-3-methoxybutanol and diacetone alcohol; aromatic hydrocarbons such as toluene and xylene; and others such as N-methyl-2-pyrrolidone, N-cyclohexyl-2-pyrrolidone, N,N-dimethylformamide, N,N-dimethylacetamide, dimethyl sulfoxide and γ-butyrolactone.

The photosensitive adhesive composition varnish may be filtered using a filter paper or a filter. There is no particular limitation on a filtration method, and pressure filtration using a filter having a retained particle diameter of 0.4 µm to 10 µm is preferable.

Examples of the method of applying a photosensitive adhesive composition varnish to a support include a spin coating method using a spinner, a spray coating method, a roll coating method, a screen printing method, or a coating method using a blade coater, a die coater, a calendar coater, a meniscus coater, a bar coater, a roll coater, a comma roll coater, a gravure coater, a screen coater, a slit die coater or the like. The thickness of a coating film varies depending on the coating technique, solid content and viscosity of the varnish and the like, and the thickness of the film after drying is preferably adjusted to 0.5 µm or more and 100 µm or less.

An oven, a hot plate, an infrared heater and the like can be used for drying. The drying temperature and the drying time may be set within a range at which the organic solvent can be vaporized, and it is preferred to appropriately set within a range at which a photosensitive resin composition coating film becomes an uncured or semi-cured state. Specifically, it is preferred to dry at a temperature within a range from 40°C to 120°C for 1 minute to several tens minutes. The temperature may be raised in a stepwise manner using these temperatures in combination. For example, a heat treatment may be carried out at 70°C, 80°C and 90°C for each 1 minute.

Next, a semiconductor device as applications of the photosensitive adhesive composition and photosensitive adhesive sheet of the present invention will be described below. The semiconductor device of the present invention means a semiconductor device in which a plurality of substrates, or a substrate and other members are bonded to each other through a cured product of a photosensitive adhesive composition.

Examples of the substrate include, but are not limited to, a semiconductor substrate, an organic substrate, an inorganic substrate, and a semiconductor element and a circuit board in which circuits are arranged on these substrates. Examples of the semiconductor substrate include semiconductor wafers such as silicone and gallium arsenide wafers, and those obtained by cutting these wafers. Examples of the organic substrate include glass/base material copper-clad laminates such as a glass cloth/epoxy copper-clad laminate; composite copper-clad laminates such as a glass nonwoven fabric/epoxy copper-clad laminate; heat-resistant and thermoplastic substrates such as a polyetherimide resin substrate, a polyetherketone resin substrate and a polysulfone-based resin substrate; flexible substrates such as a polyester copper-clad film substrate and a polyimide copper-clad film substrate; and the like. Examples of the inorganic substrate include ceramic substrates such as an alumina substrate, an aluminum nitride substrate and a silicon carbide substrate; metal-based substrates such as an aluminum base substrate and an iron base substrate; and glass substrates. Examples of a constituent material of a circuit include a conductor containing metals such as silver, gold and copper, a resistor containing an inorganic oxide, a low dielectric containing a glass-based material and/or a resin, a high dielectric containing a resin and high dielectric constant inorganic particles, an insulator containing a glass-based material and the like.

Specific examples of the semiconductor device of the present invention will be described below. Semiconductor devices having various structures have recently been proposed, and applications of the photosensitive adhesive composition of the present invention are not limited to the following examples.

A photosensitive adhesive sheet is affixed or a varnish of a photosensitive adhesive composition is applied, on silicon wafer with circuits and bumps formed thereon to form a photosensitive adhesive composition coating film. Thereafter, the photosensitive adhesive composition coating film is allowed to undergo patterning by exposure and development so as to provide the photosensitive adhesive composition coating film, which covers the bump portion, with an opening. The thus obtained silicon wafer with a photosensitive adhesive composition coating film and another silicon wafer are laminated to each other so as to be able to connect electrically through the bump, followed by thermocompression bonding. The photosensitive adhesive composition coating film is cured by heating the thus obtained laminate. A semiconductor package having a three-dimensional multi-layered structure can be obtained by repeating bonding of a silicon wafer through a cured product of a photosensitive adhesive composition coating film in such a manner.

Another example of the semiconductor device will be described. A photosensitive adhesive sheet is affixed or a varnish of a photosensitive adhesive composition is applied, on silicon wafer with an image sensor element formed thereon to form a photosensitive adhesive composition coating film. The photosensitive adhesive composition coating film is exposed and developed thereby removing a coating film on a sensor portion, while leaving a peripheral coating film. A glass substrate is laminated on the remaining photosensitive adhesive composition coating film, followed by thermocompression bonding. The photosensitive adhesive composition coating film is cured by heating the thus obtained laminate. In such a manner, there can be obtained an image sensor wafer having a hollow structure in which a semiconductor wafer and a glass substrate are bonded through a cured product of a patterned photosensitive adhesive composition coating film, as a partition wall.

A photosensitive adhesive composition, and a method of patterning a photosensitive adhesive sheet, and a method for thermocompression bonding of them to other members will be described below by way of examples.

First, a method of forming a photosensitive adhesive composition coating film on a substrate using a photosensitive adhesive composition varnish, support will be described. The photosensitive adhesive composition varnish is applied on the substrate. Examples of the coating method include a spin coating method using a spinner, a roll coating method, a screen printing and the like. The thickness of the coating film varies depending on the coating technique, solid content and viscosity of the varnish and the like, and it is preferred to apply the photosensitive adhesive composition varnish so that the thickness of the film after drying becomes 0.5 µm or more and 100 µm or less. Then, the substrate coated with the photosensitive adhesive composition varnish is dried to obtain a photosensitive adhesive composition coating film. An oven, a hot plate, an infrared heater and the like can be used for drying. The drying temperature and the drying time may be set within a range at which the organic solvent can be vaporized, and it is preferred to appropriately set within a range at which a photosensitive resin composition coating film becomes an uncured or semi-cured state. Specifically, it is preferred to dry at a temperature within a range from 50°C to 150°C for 1 minute to several tens minutes.

In case of using a photosensitive adhesive sheet which includes a protective film, the protective film is removed and then the photosensitive adhesive sheet and the substrate are bonded by thermocompression bonding so that they face each other. The thermocompression bonding can be carried out by a hot pressing treatment, a thermal laminating treatment, a thermal vacuum laminating treatment and the like. The thermocompression bonding temperature is preferably 40°C or higher from the viewpoint of adhesion to the substrate and embedding into the substrate. In order to prevent deterioration of resolution of pattern formation in exposure and development steps, caused by curing of the photosensitive adhesive sheet at the time of thermocompression bonding, thermocompression bonding temperature is preferably 150°C or lower. When the support film is removed after thermocompression bonding, the photosensitive adhesive coating film is left on the substrate.

Next, the photosensitive adhesive composition coating film formed by the above method is exposed by irradiation with chemical rays through a mask with a desired pattern. Examples of the chemical rays used for exposure include ultraviolet rays, visible rays, electron rays, X-rays and the like. In the present invention, it is preferred to use i-rays (365 nm), h-rays (405 nm) or g-ray (436 nm) of a mercury lamp. In the photosensitive adhesive sheet, when the support is a material which is transparent to these light rays, exposure may be carried out without removing the support from the photosensitive adhesive sheet.

In order to form a pattern, the unexposed portion is removed using a developing solution after exposure. The developing solution is preferably an aqueous solution of compounds exhibiting alkalinity, such as tetramethylammonium, diethanolamine, diethylaminoethanol, sodium hydroxide, potassium hydroxide, sodium carbonate, potassium carbonate, triethylamine, diethylamine, methylamine, dimethylamine, dimethylaminoethyl acetate, dimethylaminoethanol, dimethylaminoethyl methacrylate, cyclohexylamine, ethylenediamine, hexamethylenediamine. These aqueous alkali solutions may sometimes contain one or plural kinds selected from polar solvents such as N-methyl-2-pyrrolidone, N,N-dimethylformamide, N,N-dimethylacetamide, dimethyl sulfoxide, γ-butyrolactone and dimethylacrylamide; alcohols such as methanol, ethanol and isopropanol; esters such as ethyl lactate and propylene glycol monomethyl ether acetate; ketones such as cyclopentanone, cyclohexanone, isobutylketone and methyl isobutyl ketone; and the like.

The development can be carried out by a method in which the above developing solution is sprayed over a surface of a coating film of a substrate, a method in which a coating film is dipped in the developing solution, together with the substrate and the like. Ultrasonic wave may be applied while dipping a substrate in the developing solution. In addition, the developing solution may be sprayed over a surface of a coating film while rotating a substrate. The conditions at the time of development, such as developing time, developing step, and temperature of a developing solution may be conditions which enable removal of the unexposed portion. In order to process a fine pattern and to remove the residue between patterns, it is preferred that the development is further carried out after removal of the unexposed portion.

After the development, a rinsing treatment may be carried out using water. The rinsing treatment may be carried out using water containing alcohols such as ethanol and isopropyl alcohol, or esters such as ethyl lactate and propylene glycol monomethyl ether acetate added therein.

When the resolution of a pattern at the time of development is improved and a permissible range of the development conditions becomes wider, the step of performing a baking treatment before development may be included. The temperature of the baking treatment is preferably within a range from 50 to 180°C, and more preferably from 60 to 120°C. The time of the baking treatment is preferably from 5 seconds to several hours.

After formation of a pattern, a heating and drying operation is preferably performed within a range from 60 to 200°C from the viewpoint of reducing the solvent, volatile component, water and the like which remain in a photosensitive adhesive composition coating film. The heating and drying time is preferably from 1 minute to several hours.

The thus obtained substrate with a patterned photosensitive adhesive composition coating film formed thereon is thermocompression-bonded to other substrates and members. The thermocompression bonding temperature may be a glass transition temperature of a resin, which forms a coating film, or higher, and preferably a temperature within a range from 100 to 400°C. The pressure at the time of compression bonding is preferably within a range from 0.01 to 10 MPa. The time is preferably from 1 second to several minutes.

After the thermocompression bonding, the photosensitive adhesive composition coating film is converted into a cured film by heating at a temperature within a range from 120°C to 400°C. The heating temperature is preferably 150°C or higher and 300°C or lower, and more preferably 180°C or higher and 250°C or lower. The heat treatment may be carried out by raising a temperature in a stepwise or continuous manner within a predetermined temperature range. The heat treatment time is preferably from 5 minutes to 5 hours. For example, the heat treatment is carried out at 130°C and 200°C for each 30 minutes. Alternatively, the temperature is linearly raised from room temperature to 250°C over 2 hours.

The adhesive strength of the adhesive body thus obtained by thermocompression bonding is desirably 40 MPa or more from the viewpoint of adhesion reliability. The adhesive strength is more desirably 50 MPa or more.

The thickness of the cured film can be optionally set, and is preferably 0.5 µm or more and 100 µm or less.

### Examples

The present invention will be specifically described by way of Examples, but the present invention is not limited thereto. In the respective Examples, details of raw materials indicated by abbreviations are shown below.

### <Raw Materials of Polyimide>

ODPA: 4,4'-oxydiphthalic dianhydride (manufactured by MANAC Incorporated)
6FDA: 4,4'-(hexafluoroisopropylidene)diphthalic dianhydride (manufactured by Daikin Industries, Ltd.)
BAHF: 2,2-bis(3-amino-4-hydroxyphenyl)hexafluoropropane (manufactured by AZ Electronic Materials)
MBAA: [bis(4-amino-3-carboxy)phenyl]methane (manufactured by WAKAYAMA SEIKA KOGYO Co., LTD.)
SiDA: bis(3-aminopropyl)tetramethyldisiloxane (manufactured by Shin-Etsu Chemical Co., Ltd.)
MAP: 3-aminophenol (manufactured by Chemical Industry Co., Ltd.)
D-230: polyoxypropylenediamine (manufactured by MITSUI FINE CHEMICAL Inc. under the trade name of "JEFFAMINE" D-230, "a" in the general formula (4) is from 2 to 3)
D-400: polyoxypropylenediamine (manufactured by MITSUI FINE CHEMICAL Inc. under the trade name of "JEFFAMINE" D-400, "a" in the general formula (4) is from 5 to 7).

### <Photopolymerizable compounds>

BP-6EM: ethylene oxide-modified bisphenol A dimethacrylate (manufactured by KYOEISHA CHEMICAL Co., Ltd. under the trade name of "BP-6EM")
DCP-A: tricyclodecanedimethanol diacrylate (manufactured by KYOEISHA CHEMICAL Co., Ltd. under the trade name of "DCP-A")
MOI-BP: 2-isocyanate ethyl methacrylate block compound (manufactured by Showa Denko K.K. under "Karenz" (registered trademark)" MOI-BP)
DPE-6A: dipentaerythritol hexaacrylate (manufactured by KYOEISHA CHEMICAL Co., Ltd. under the trade name of "DPE-6A")

### <Epoxy Compounds>

EP4003S: propylene oxide-modified BisA type epoxy resin (manufactured by ADEKA Corporation under the trade name of "ADEKA RESIN (registered trademark)" EP-4003S, m + n in the general formula (1) is from 5 to 6
EP4000S: propylene oxide-modified BisA type epoxy resin (manufactured by ADEKA Corporation under the trade name of "ADEKA RESIN (registered trademark)" EP-4000S, m + n in the general formula (1) is from 1 to 2
EP4010S: propylene oxide-modified BisA type epoxy resin (manufactured by ADEKA Corporation under the trade name of "ADEKA RESIN (registered trademark)" EP-4010S, dimer of the general formula (1) in which m + n is from 1 to 2 (i.e., a compound represented by the following formula (6))

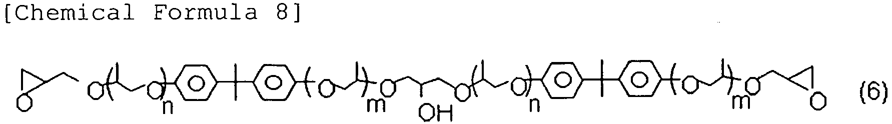

850S: BisA type epoxy resin (manufactured by DIC Corporation under the trade name of "EPICLON (registered trademark)" 850S, m + n in the general formula (1) is 0).

### <Photopolymerization Initiator>

NCI831: photoradical polymerization initiator (manufactured by ADEKA Corporation under the trade name of "NCI-831")

### <Surfactant>

L1980: "DISPARLON (registered trademark)" L1980 (manufactured by KUSUMOTO CHEMICALS Co., Ltd.)

### <Solvent>

γBL: γ-butyrolactone

Evaluation methods in the respective Examples and Comparative Examples are shown below.

### <Molecular Weight of Polyimide>

Using a solution having a solid content of 0.1% by weight prepared by dissolving polyimide in NMP (N-methyl pyrrolidone), the measurement was carried out by a GPC apparatus Waters 2690 with the constitution shown below (manufactured by Nihon Waters K.K.) and a polystyrene-equivalent weight average molecular weight was calculated. GPC measuring conditions are as follows. An NMP solution prepared by dissolving LiCl and phosphoric acid in each concentration of 0.05 mol/L was used as a mobile phase and a developing speed was set at 0.4 ml/minute.
Detector: Waters 996
System controller: Waters 2690
Column oven: Waters HTR-B
Thermo controller: Waters TCM
Column: TOSOH grard comn
Column: TOSOH TSK-GEL α-4000
Column: TOSOH TSK-GEL α-2500

### <Imidation Ratio of Polyimide>

First, an infrared absorption spectrum of a polymer was measured and the existence of adsorption peaks (about 1,780 cm⁻¹, about 1,377 cm⁻¹) of an imide structure attributed to polyimide was confirmed. The polymer was subjected a heat treatment at 350°C for 1 hour and then the infrared absorption spectrum was measured again. A comparison was made between the peak intensity at about 1,377 cm⁻¹ before and after the heat treatment. Assuming that an imidation ratio of the polymer after the heat treatment is 100%, an imidation ratio of the polymer before the heat treatment was determined by a peak intensity ratio.

### <Bondability to Silicon Wafer>

Each of the photosensitive adhesive composition varnishes prepared in the respective Examples and Comparative Examples was applied on a 38 µm thick PET film using a comma roll coater and dried at 100°C for 15 minutes, and then a 10 µm thick PP film as a protective film was laminate to obtain a photosensitive adhesive sheet. Application was carried out so that the thickness of the obtained photosensitive adhesive composition coating film becomes 25 µm. Thereafter, the protective film was removed and the release surface was laminated on a silicon wafer using a lamination machine (VTM-200M, manufactured by Takatori Corporation) under the conditions of a stage temperature of 80°C, a roll temperature of 80°C, a pressure of 150 Pa, an affixing rate of 5 mm/second and an affixing pressure of 0.2 MPa. Samples where the photosensitive adhesive composition coating film does not remain on a support film when the support film is removed, and affixed to the silicon wafer were rated "A", samples where the photosensitive adhesive composition coating film is partially affixed were rated "B", and samples where the photosensitive adhesive composition coating film remains on the support film without being affixed were rated "C", respectively.

### <Evaluation of Resolution>

The protective film of the photosensitive adhesive sheet obtained in the same manner as described above was removed and the release surface was laminated on a silicon wafer using a lamination machine (VTM-200M, manufactured by Takatori Corporation) under the conditions of a stage temperature of 80°C, a roll temperature of 80°C, a pressure of 150 Pa, an affixing rate of 5 mm/second and an affixing pressure of 0.2 MPa. After removing the support film, a mask having a pattern [L/S (line-and-space) = 75/75, 50/50, 40/40, 30/30, 25/25 µm] was set to an exposure apparatus using an ultrahigh-pressure mercury lamp as a light source, and then exposure was carried out in an exposure dose of 400 mJ/cm² (in terms of h-rays). After exposure, the unexposed portion was removed by dip development using an aqueous 2.38% solution of tetramethylammonium hydroxide, and then a rinsing treatment was carried out using water. The development time was set at the time which is two times longer than the time required to completely dissolve the unexposed portion. The thus obtained pattern was observed by an optical microscope and the size of a minimum pattern whose line is free from abnormality such as clogging was used as an item for evaluation of resolution.

### <Evaluation of Thermocompression Bondability of Photosensitive Adhesive Sheet>

The protective film of the photosensitive adhesive sheet obtained in the same manner as described above was removed and the release surface was laminated on a silicon wafer using a lamination machine (VTM-200M, manufactured by Takatori Corporation) under the conditions of a stage temperature of 80°C, a roll temperature of 80°C, a pressure of 150 Pa, an affixing rate of 5 mm/second and an affixing pressure of 0.2 MPa. After removing the support film, exposure was carried out in an exposure dose of 400 mJ/cm² (in terms of h-rays) using an ultrahigh-pressure mercury lamp as a light source. The thus obtained silicon wafer with a photosensitive adhesive composition coating film was cut in to a size measuring 50 × 50 mm, and then placed on a hot plate with the photosensitive adhesive composition coating film upward and maintained for 1 minute. After 1 minute, a silicon wafer measuring 2 × 2 mm was placed thereon and the temperature was raised in increments of 10°C from 100°C and then a test was carried out. The minimum temperature at which tack properties are exhibited in the photosensitive adhesive composition coating film to cause adhesion with the silicon wafer was regarded as a thermocompression bonding temperature. The lower the temperature at which tack properties are exhibited, the better.

### <Evaluation of Thermal Flow Amount of Photosensitive Adhesive Sheet>

The protective film of the photosensitive adhesive sheet obtained in the same manner as described above was removed, and then exposure was carried out in an exposure dose of 400 mJ/cm² (in terms of h-rays) by an exposure apparatus using an ultrahigh-pressure mercury lamp as a light source. After exposure, the photosensitive adhesive sheet was cut into size measuring 5 × 5 mm. The cut sample was affixed on a glass plate heated on a hot plate at 150°C so that the glass plate is in contact with the photosensitive adhesive composition coating film, and then a pressure was applied above the support film by placing a weight of 500 g for 30 seconds. After 30 seconds, the photosensitive adhesive sheet bonded to the glass plate was observed by an optical microscope and the length of the portion, at which the length of the photosensitive adhesive composition projected from the support film is a maximum length, was measured. (Length projected from support film)/(length (5 mm) before compression bonding) was calculated as a thermal flow amount.

### <Evaluation of Adhesive Strength>

The protective film of the photosensitive adhesive sheet obtained in the same manner as described above was removed and the release surface was laminated on a silicon wafer using a lamination machine (VTM-200M, manufactured by Takatori Corporation) under the conditions of a stage temperature of 80°C, a roll temperature of 80°C, a pressure of 150 Pa, an affixing rate of 5 mm/second and an affixing pressure of 0.2 MPa. After removing the support film, exposure was carried out in an exposure dose of 400 mJ/cm² (in terms of h-rays) by an exposure apparatus using an ultrahigh-pressure mercury lamp as a light source. After exposure, the silicon wafer with a photosensitive adhesive composition coating film was cut into a size measuring 50 × 50 mm, and then placed on a hot plate at 150°C with the photosensitive adhesive composition coating film upward, and maintained for 1 minute. After 1 minute, a silicon wafer measuring 2 × 2 mm was placed thereon and then thermocompression bonding was carried out under a pressure of 0.2 MPa over 30 seconds. Thereafter, curing was carried out by heating in an inert oven at 250°C under a nitrogen atmosphere for 60 minutes to obtain a sample of silicon wafers which are bonded to each other. Then, the adhesive strength was evaluated at a temperature of 30°C using a die shear tester (Dage series 4000).
Sample size: 2 mm × 2 mm
Testing speed: 200 µm/s
Testing height: 300 µm

### <Insulation Stability Test>

On a copper comb electrode (L/S = 10 µm/10 µm), each of the photosensitive resin compositions prepared in the respective Examples and Comparative Examples was applied using a tip of tweezers, and then dried in atmospheric air at 100°C for 15 minutes. Next, an exposure treatment was carried out in an exposure dose of 400 mJ/cm² (in terms of h-rays) using an ultrahigh-pressure mercury lamp and then a heat treatment was carried out at 200°C for 60 minutes under an N₂ atmosphere using an inert oven to obtain a sample for evaluation. An insulation stability test was carried out for 1,000 hours by continuously applying a voltage of 20 V between electrodes of the obtained sample for evaluation under an atmosphere of a temperature of 85°C and a relative humidity of 85%. When an inter-line insulation resistance value was 1 × 10⁴ Ω or more after 1,000 hours, insulation stability was regarded as 1,000 hours. When the inter-line insulation resistance value became less than 1 × 10⁴ Ω or more during the test, that testing time was regarded as the value of insulation stability. The copper comb electrode used is a copper comb electrode in which a 0.4 µm thick thermal oxide film, a 0.8 µm thick silicon nitride film, a 0.08 µm thick chromium base electrode and a 10 µm thick copper electrode are laminated in this order on a silicone substrate and then patterning is carried out.

### Example 1

### (Polymerization of polyimide)

After a 300 ml four-necked flask was equipped with a stirrer, a thermometer, a nitrogen introducing tube and a dropping funnel, 92.60 g of γBL and 31.02 g of ODPA were charged therein and then dissolved at 60°C by stirring under a nitrogen atmosphere. While stirring at 60°C, 2.18 g of MAP, 1.24 g of SiDA, 7.14 g of D-230 and 20.14 g of BAHF were added, followed by stirring for 1 hour. After heating to 180°C, stirring for 2 hours and further cooling to room temperature, a soluble polyimide solution A (solid content of 40.0% by weight) was obtained. The obtained soluble polyimide showed a weight average molecular weight of 20,050 and an imidation ratio of 95%. The soluble polyimide (0.1 g or more) dissolved in 100 g of an aqueous 2.38% solution of tetramethylammonium hydroxide at 25°C, and was alkali soluble.

### (Production and evaluation of photosensitive resin composition)

To the 8.8 g of the soluble polyimide solution A obtained by the method described above, 1.8 g of BP-6EM, 0.2 g of DPE-6A, 0.2 g of NCI831, 2.5 g of EP4003S and 0.02 g of L1980 were added, followed by mixing with stirring to obtain a photosensitive adhesive composition varnish as a viscous liquid. With respect to the obtained photosensitive adhesive composition, bondability to a silicon wafer, resolution, thermocompression bondability, thermal flow amount, adhesive strength and insulation stability were evaluated by the procedures described above.

### Example 2

After a 300 ml four-necked flask was equipped with a stirrer, a thermometer, a nitrogen introducing tube and a dropping funnel, 98.37 g of γBL and 31.02 g of ODPA were charged therein and then dissolved at 60°C by stirring under a nitrogen atmosphere. While stirring at 60°C, 2.18 g of MAP, 1.24 g of SiDA and 31.13 g of BAHF were added, followed by stirring for 1 hour. After heating to 180°C, stirring for 2 hours and further cooling to room temperature, a soluble polyimide solution B (solid content: 40.0% by weight) was obtained. The obtained soluble polyimide showed a weight average molecular weight of 28,500 and an imidation ratio of 99%. The soluble polyimide (0.1 g or more) dissolved in 100 g of an aqueous 2.38% solution of tetramethylammonium hydroxide at 25°C, and was alkali soluble. The thus obtained soluble polyimide solution B was mixed with the respective components in the same manner as in Example 1 to obtain a photosensitive adhesive composition varnish. With respect to the obtained photosensitive adhesive composition, bondability to a silicon wafer, resolution, thermocompression bondability and adhesive strength were evaluated by the procedures described above.

### Example 3

To 8.8 g of the soluble polyimide solution A obtained in Example 1, 1.8 g of BP-6EM, 0.2 g of DPE-6A, 0.2 g of NCI831, 1.5 g of EP4003S and 0.02 g of L1980 were added, followed by mixing with stirring to obtain a photosensitive adhesive composition varnish as a viscous liquid. With respect to the obtained photosensitive adhesive composition, bondability to a silicon wafer, resolution, thermocompression bondability, thermal flow amount, adhesive strength and insulation stability were evaluated by the procedures described above.

### Example 4

To 8.8 g of the soluble polyimide solution A obtained in Example 1, 1.8 g of BP-6EM, 0.2 g of DPE-6A, 0.2 g of NCI831, 1.0 g of EP4003S and 0.02 g of L1980 were added, followed by mixing with stirring to obtain a photosensitive adhesive composition varnish as a viscous liquid. With respect to the obtained photosensitive adhesive composition, bondability to a silicon wafer, resolution, thermocompression bondability, thermal flow amount, adhesive strength and insulation stability were evaluated by the procedures described above.

### Example 5

To 8.8 g of the soluble polyimide solution A obtained in Example 1, 1.8 g of BP-6EM, 0.2 g of DPE-6A, 0.2 g of NCI831, 1.0 g of EP4000S and 0.02 g of L1980 were added, followed by mixing with stirring to obtain a photosensitive adhesive composition varnish as a viscous liquid. With respect to the obtained photosensitive adhesive composition, bondability to a silicon wafer, resolution, thermocompression bondability, thermal flow amount, adhesive strength and insulation stability were evaluated by the procedures described above.

### Example 6

To 8.8 g of the soluble polyimide solution A obtained in Example 1, 1.8 g of BP-6EM, 0.2 g of DPE-6A, 0.2 g of NCI831, 0.8 g of EP4003S and 0.02 g of L1980 were added, followed by mixing with stirring to obtain a photosensitive adhesive composition varnish as a viscous liquid. With respect to the obtained photosensitive adhesive composition, bondability to a silicon wafer, resolution, thermocompression bondability, thermal flow amount, adhesive strength and insulation stability were evaluated by the procedures described above.

### Example 7

After a 300 ml four-necked flask was equipped with a stirrer, a thermometer, a nitrogen introducing tube and a dropping funnel, 88.75 g of γBL and 31.02 g of ODPA were charged therein and then dissolved at 60°C by stirring under a nitrogen atmosphere. While stirring at 60°C, 2.18 g of MAP, 1.24 g of SiDA, 11.9 g of D-230 and 12.82 g of BAHF were added, followed by stirring for 1 hour. After heating to 180°C, stirring for 2 hours and further cooling to room temperature, a soluble polyimide solution C (solid content of 40.0% by weight) was obtained. The obtained soluble polyimide (0.1 g or more) dissolved in 100 g of an aqueous 2.38% solution of tetramethylammonium hydroxide at 25°C, and was alkali soluble. The obtained soluble polyimide showed a weight average molecular weight of 19,000 and an imidation ratio of 98%. The thus obtained soluble polyimide solution C was mixed with the respective components in the same manner as in Example 6 to obtain a photosensitive adhesive composition varnish. With respect to the obtained photosensitive adhesive composition, bondability to a silicon wafer, resolution, thermocompression bondability, thermal flow amount, adhesive strength and insulation stability were evaluated by the procedures described above.

### Example 8

After a 300 ml four-necked flask was equipped with a stirrer, a thermometer, a nitrogen introducing tube and a dropping funnel, 101.46 g of γBL and 31.02 g of ODPA were charged therein and then dissolved at 60°C by stirring under a nitrogen atmosphere. While stirring at 60°C, 2.18 g of MAP, 1.24 g of SiDA, 13.05 g of D-400 and 20.14 g of BAHF were added, followed by stirring for 1 hour. After heating to 180°C, stirring for 2 hours and further cooling to room temperature, a soluble polyimide solution D (solid content of 40.0% by weight) was obtained. The obtained soluble polyimide showed a weight average molecular weight of 19,950 and an imidation ratio of 99%. The soluble polyimide (0.1 g or more) dissolved in 100 g of an aqueous 2.38% solution of tetramethylammonium hydroxide at 25°C, and was alkali soluble. The thus obtained soluble polyimide solution D was mixed with the respective components in the same manner as in Example 6 to obtain a photosensitive adhesive composition varnish. With respect to the obtained photosensitive adhesive composition, bondability to a silicon wafer, resolution, thermocompression bondability, thermal flow amount, adhesive strength and insulation stability were evaluated by the procedures described above. Also resolution was evaluated. As a result, a fine pattern with a pitch of 75 µm or less was partially peeled off.

### Example 9

After a 300 ml four-necked flask was equipped with a stirrer, a thermometer, a nitrogen introducing tube and a dropping funnel, 96.06 g of γBL, 15.51 g of ODPA and 22.21 g of 6FDA were charged therein and then dissolved at 60°C by stirring under a nitrogen atmosphere. While stirring at 60°C, 2.18 g of MAP, 1.24 g of SiDA, 7.14 g of D-230 and 20.14 g of BAHF were added, followed by stirring for 1 hour. After heating to 180°C, stirring for 2 hours and further cooling to room temperature, a soluble polyimide solution E (solid content of 40.0% by weight) was obtained. The obtained soluble polyimide showed a weight average molecular weight of 22,100 and an imidation ratio of 96%. The soluble polyimide (0.1 g or more) dissolved in 100 g of an aqueous 2.38% solution of tetramethylammonium hydroxide at 25°C, and was alkali soluble. The thus obtained soluble polyimide solution E was mixed with the respective components in the same manner as in Example 4 to obtain a photosensitive adhesive composition varnish. With respect to the obtained photosensitive adhesive composition, bondability to a silicon wafer, resolution, thermocompression bondability, thermal flow amount, adhesive strength and insulation stability were evaluated by the procedures described above.

### Comparative Example 1

To 8.8 g of the soluble polyimide solution A obtained in Example 1, 1.8 g of BP-6EM, 0.2 g of DPE-6A, 0.2 g of NCI831 and 0.02 g of L1980 were added, followed by mixing with stirring to obtain a photosensitive adhesive composition varnish as a viscous liquid. With respect to the obtained photosensitive adhesive composition, bondability to a silicon wafer, resolution, thermocompression bondability, thermal flow amount, adhesive strength and insulation stability were evaluated by the procedures described above.

### Comparative Example 2

After a 300 ml four-necked flask was equipped with a stirrer, a thermometer, a nitrogen introducing tube and a dropping funnel, 86.89 g of γBL and 31.02 g of ODPA were charged therein and then dissolved at 60°C by stirring under a nitrogen atmosphere. While stirring at 60°C, 2.18 g of MAP, 17.40 g of SiDA and 7.33 g of BAHF were added, followed by stirring for 1 hour. After heating to 180°C, stirring for 2 hours and further cooling to room temperature, a soluble polyimide solution F (solid content of 40.0% by weight) was obtained. The obtained soluble polyimide showed a weight average molecular weight of 17,200 and an imidation ratio of 96%. The soluble polyimide (0.1 g or more) was not dissolved in 100 g of an aqueous 2.38% solution of tetramethylammonium hydroxide at 25°C, and was not alkali soluble. The thus obtained soluble polyimide solution F was mixed with the respective components in the same manner as in Comparative Example 1 to obtain a photosensitive adhesive composition varnish. With respect to the obtained photosensitive adhesive composition, bondability to a silicon wafer, resolution, thermocompression bondability, thermal flow amount, adhesive strength and insulation stability were evaluated by the procedures described above. Since the polyimide F was not alkali soluble, a pattern could not be formed.

### Comparative Example 3

After a 300 ml four-necked flask was equipped with a stirrer, a thermometer, a nitrogen introducing tube and a dropping funnel, 99.04 g of γBL and 31.02 g of ODPA were charged therein and then dissolved at 60°C by stirring under a nitrogen atmosphere. While stirring at 60°C, 2.18 g of MAP, 2.49 g of SiDA, 8.59 g of MBAA and 21.75 g of D-400 were added, followed by stirring for 1 hour. After heating to 180°C, stirring for 2 hours and further cooling to room temperature, a soluble polyimide solution G (solid content of 40.0% by weight) was obtained. The obtained soluble polyimide showed a weight average molecular weight of 16,800 and an imidation ratio of 99%. The soluble polyimide (0.1 g or more) was dissolved in 100 g of an aqueous 2.38% solution of tetramethylammonium hydroxide at 25°C, and was alkali soluble. The thus obtained soluble polyimide solution G was mixed with the respective components in the same manner as in Comparative Example 1 to obtain a photosensitive adhesive composition varnish. With respect to the obtained photosensitive adhesive composition, bondability to a silicon wafer, resolution, thermocompression bondability, thermal flow amount, adhesive strength and insulation stability were evaluated by the procedures described above. However, affixing to a silicon wafer could not be carried out.

Therefore, the obtained photosensitive adhesive composition varnish was directly spin-coated on a silicon wafer and then dried on a hot plate at 100°C for 5 minutes. The photosensitive adhesive composition varnish was coated so that the thickness of the film after drying becomes 25 µm. With respect to the obtained coated silicon wafer, resolution, thermocompression bondability, thermal flow amount, adhesive strength and insulation stability were evaluated by the procedures analogous to the above procedures.

### Comparative Example 4

To 8.8 g of the soluble polyimide solution B obtained in Example 2, 1.8 g of BP-6EM, 0.2 g of DPE-6A, 0.2 g of NCI831, 0.8 g of EP4010S and 0.02 g of L1980 were added, followed by mixing with stirring to obtain a photosensitive adhesive composition varnish as a viscous liquid. With respect to the obtained photosensitive adhesive composition, bondability to a silicon wafer, resolution, thermocompression bondability and adhesive strength were evaluated by the procedures described above. Since EP4010S is a dimer of an epoxy compound and has a long repetitive length, developability decreases and thus a pattern could not be formed.

### Comparative Example 5

To 8.8 g of the soluble polyimide solution B obtained in Example 2, 1.8 g of BP-6EM, 0.2 g of DPE-6A, 0.2 g of NCI831, 0.8 g of 850S and 0.02 g of L1980 were added, followed by mixing with stirring to obtain a photosensitive adhesive composition varnish as a viscous liquid. With respect to the obtained photosensitive adhesive composition, bondability to a silicon wafer, resolution, thermocompression bondability and adhesive strength were evaluated by the procedures described above. Since an epoxy compound of 850S has low hydrophilicity, developability decreases and thus a pattern could not be formed.

Formulations of the photosensitive adhesive compositions obtained in the respective Examples and Comparative Examples are shown in Tables 1 to 2, and the evaluation results are shown in Tables 3 to 4.

**Table 1**

| | | | | Example 1 | Example 2 | Example 3 | Example 4 | Example 5 | Example 6 | Example 7 |
|---|---|---|---|---|---|---|---|---|---|---|
| Polyimide | Raw monomer and copolymerization ratio (molar ratio) | Tetracarboxylic dianhydride | ODPA | 100 | 100 | 100 | 100 | 100 | 100 | 100 |
| | | Acid anhydride of formula (3) | 6FDA | None | None | None | None | None | None | None |
| | | Diamine of formula (2) | BAHF | 55 | 85 | 55 | 55 | 55 | 55 | 35 |
| | | Diamine of formula (4) | D230 | 30 | None | 30 | 30 | 30 | 30 | 50 |
| | | | D400 | None | None | None | None | None | None | None |
| | | Other diamine | MBAA | None | None | None | None | None | None | None |
| | | | SiDA | 5 | 5 | 5 | 5 | 5 | 5 | 5 |
| | | Monoamine | MAP | 20 | 20 | 20 | 20 | 20 | 20 | 20 |
| | Imidation ratio (%) | | | 95 | 99 | 95 | 95 | 95 | 95 | 98 |
| | Weight average molecular weight | | | 20,050 | 28,500 | 20,050 | 20,050 | 20,050 | 20,050 | 19,000 |
| Photosensitive adhesive | Mixed substance and content (parts by weight) | (B) Polyimide | | 3.5 | 3.5 | 3.5 | 3.5 | 3.5 | 3.5 | 3.5 |
| | | (C) Compound having photopolymerizable group | BP-6EM | 1.8 | 1.8 | 1.8 | 1.8 | 1.8 | 1.8 | 1.8 |
| | | | DPE-6A | 0.2 | 0.2 | 0.2 | 0.2 | 0.2 | 0.2 | 0.2 |
| | | Photopolymerization initiator | NCI831 | 0.2 | 0.2 | 0.2 | 0.2 | 0.2 | 0.2 | 0.2 |
| | | (A) Epoxy of formula (1) | EP4003S | 2.5 | 2.5 | 1.5 | 1.0 | None | 0.8 | 0.8 |
| | | | EP4000S | None | None | None | None | 1.0 | None | None |
| | | (A) Other epoxy | EP4010S | None | None | None | None | None | None | None |
| | | | 850S | None | None | None | None | None | None | None |
| | | Surfactant | L1980 | 0.02 | 0.02 | 0.02 | 0.02 | 0.02 | 0.02 | 0.02 |
| | [Amount of (A)/(amount of (A) + (B) + (C))] × 100 (%) | | | 31.3 | 31.3 | 21.4 | 15.4 | 15.4 | 12.7 | 12.7 |

**Table 2**

| | | | | Example 8 | Example 9 | Com. Example 1 | Com. Example 2 | Com. Example 3 | Com. Example 4 | Com. Example 5 |
|---|---|---|---|---|---|---|---|---|---|---|
| Polyimide | Raw monomer and copolymerization ratio (molar ratio) | Tetracarboxylic dianhydride | ODPA | 100 | 50 | 100 | 100 | 100 | 100 | 100 |
| | | Acid anhydride of formula (3) | 6FDA | None | 50 | None | None | None | None | None |
| | | Diamine of formula (2) | BAHF | 55 | 55 | 55 | 20 | None | 85 | 85 |
| | | Diamine of formula (4) | D230 | None | 30 | 30 | None | None | None | None |
| | | | D400 | 30 | None | None | None | 50 | None | None |
| | | Other diamine | MBAA | None | None | None | None | 30 | None | None |
| | | | SiDA | 5 | 5 | 5 | 70 | 10 | 5 | 5 |
| | | Monoamine | MAP | 20 | 20 | 20 | 20 | 20 | 20 | 20 |
| | Imidation ratio (%) | | | 99 | 96 | 99 | 96 | 99 | 95 | 95 |
| | Weight average molecular weight | | | 19,950 | 22,100 | 20,050 | 17,200 | 16,800 | 28,500 | 28,500 |
| Photosensitive adhesive | Mixed substance and content (parts by (A) weight) | (B) Polyimide | | 3.5 | 3.5 | 3.5 | 3.5 | 3.5 | 3.5 | 3.5 |
| | | (C) Compound having photopolymerizable group | BP-6EM | 1.8 | 1.8 | 1.8 | 1.8 | 1.8 | 1.8 | 1.8 |
| | | | DPE-6A | 0.2 | 0.2 | 0.2 | 0.2 | 0.2 | 0.2 | 0.2 |
| | | Photopolymerization initiator | NCI831 | 0.2 | 0.2 | 0.2 | 0.2 | 0.2 | 0.2 | 0.2 |
| | | (A) Epoxy of formula (1) | EP4003S | 0.8 | 1.0 | None | None | 1.0 | None | None |
| | | | EP4000S | None | None | None | None | None | None | None |
| | | (A) Other epoxy | EP4010S | None | None | None | None | None | 1.0 | None |
| | | | 850S | None | None | None | None | None | None | None |
| | | Surfactant | L1980 | 0.02 | 0.02 | 0.02 | 0.02 | 0.02 | 0.02 | 0.02 |
| | [Amount of (A)/(amount of (A) + (B) + (C))] × 100 (%) | | | 12.7 | 15.4 | 0 | 0 | 15.4 | 15.4 | 15.4 |

**Table 3**

| | Example 1 | Example 2 | Example 3 | Example 4 | Example 5 | Example 6 | Example 7 |
|---|---|---|---|---|---|---|---|
| Affixing properties | A | A | A | A | A | A | A |
| L/S resolution (µm) | 50/50 | 40/40 | 30/30 | 30/30 | 75/75 | 30/30 | 75/75 |
| Thermocompression bodability) | 100 | 100 | 100 | 100 | 120 | 140 | 120 |
| Thermal flow amount (%) | 7.0 | 6.2 | 4.3 | 2.5 | 2.3 | 1.5 | 1.9 |
| Adhesive strength (MPa) | 70 | 80 | 66 | 60 | 70 | 58 | 48 |
| Insulation reliability | 1,000 hours | 1,000 hours | 1,000 hours | 1,000 hours | 1,000 hours | 1,000 hours | 1,000 hours |

**Table 4**

| | Example 8 | Example 9 | Com. Example 1 | Com. Example 2 | Com. Example 3 | Com. Example 4 | Com. Example 5 |
|---|---|---|---|---|---|---|---|
| Affixing properties | A | A | A | A | C | A | A |
| L/S resolution (µm) | 75/75 | 30/30 | 75/75 | Indevelopable | 100/100 | Indevelopable | Indevelopable |
| Thermocompression bodability) | 120 | 100 | 160 | 120 | 120 | 160 | 160 |
| Thermal flow amount (%) | 1.6 | 2.4 | 0 | 0 | 2.9 | 2.3 | 2.6 |
| Adhesive strength (MPa) | 50 | 63 | 10 | 15 | 42 | 45 | 85 |
| Insulation reliability | 1,000 hours | 1,000 hours | 1,000 hours | 1,000 hours | 300 hours | 1,000 hours | 1,000 hours |

### Industrial Applicability

According to the present invention, it is possible to obtain a photosensitive adhesive composition which can be developed with an alkali developing solution after exposure, and exhibits high adhesive strength in case of thermocompression bonding on a substrate, and is also excellent in insulation stability.

The photosensitive adhesive composition of the present invention, and a photosensitive adhesive sheet using the same is preferably used so as to produce a semiconductor package having a three-dimensional structure, and a hollow package such as an image sensor.

## Claims

1. A photosensitive adhesive composition comprising:
(A) an epoxy compound,
(B) a soluble polyimide,
(C) a photopolymerizable compound, and
(D) a photopolymerization initiator, wherein
the epoxy compound (A) contains an epoxy compound represented by the general formula (1), and also the soluble polyimide (B) has a residue of diamine represented by the general formula (2): 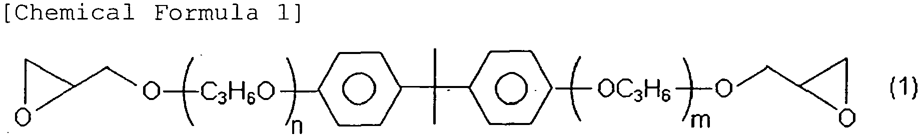 wherein m and n in the general formula (1) are integers of 0 or more, which satisfy the relationship: 1 ≤ m + n ≤ 10; and 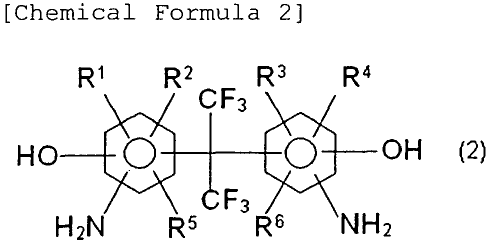 wherein R¹ to R⁸ in the general formula (2) may be respectively the same or different, and selected from the group consisting of a hydrogen atom, an alkyl group having 1 to 30 carbon atoms, an alkoxy group having 1 to 30 carbon atoms, a halogen, a sulfone group, a nitro group and a cyano group.

2. The photosensitive adhesive composition according to claim 1, wherein the content of the epoxy compound (A) is 15% by weight or more and 50% by weight or less based on the total amount of components (A) to (C).

3. The photosensitive adhesive composition according to claim 1 or 2, wherein the soluble polyimide (B) has a residue of an acid anhydride represented by the general formula (3):

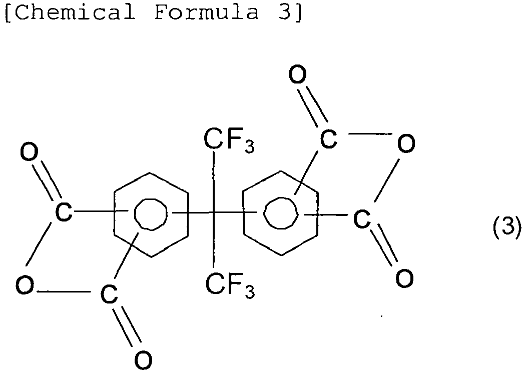

4. The photosensitive adhesive composition according to any one of claims 1 to 3, wherein the soluble polyimide (B) further has a residue of diamine represented by the general formula (4): 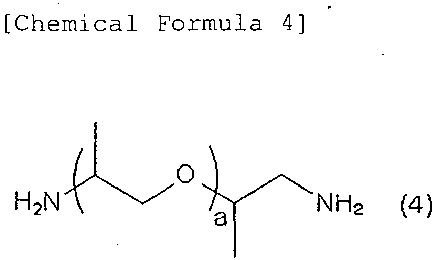 wherein "a" in the general formula (4) represents a range between 2 to 10.

5. The photosensitive adhesive composition according to claim 4, wherein the residue of diamine represented by the general formula (4) accounts for 50 mol% or less of the entire diamine residue.

6. A photosensitive adhesive sheet comprising a support and a coating film of the photosensitive adhesive composition according to any one of claims 1 to 5 formed on the support.

7. A semiconductor device comprising a plurality of substrates or a substrate and other members, which are bonded to each other through a cured product of the photosensitive adhesive composition according to any one of claims 1 to 5.

## Patentansprüche

1. Lichtempfindliche Klebezusammensetzung, umfassend:
(A) eine Epoxid-Verbindung,
(B) ein lösliches Polyimid,
(C) eine photopolymerisierbare Verbindung, und
(D) einen Photopolymerisationsinitiator, wobei
die Epoxid-Verbindung (A) eine durch die allgemeine Formel (1) dargestellte Epoxid-Verbindung enthält, und auch das lösliche Polyimid (B) einen durch die allgemeine Formel (2) dargestellten Rest eines Diamins aufweist: 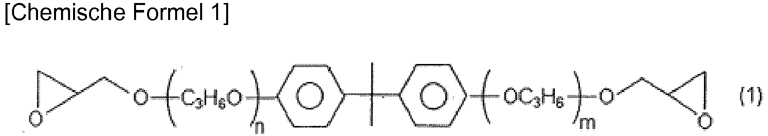 wobei m und n in der allgemeinen Formel (1) ganze Zahlen von 0 oder mehr sind, welche die Beziehung: 1 ≤ m + n ≤ 10 erfüllen;
und 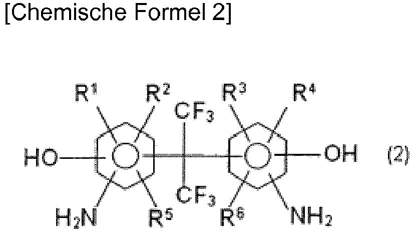 wobei R¹ bis R⁸ in der allgemeinen Formel (2) jeweils gleich oder unterschiedlich sein können, und ausgewählt sind aus der Gruppe bestehend aus einem Wasserstoffatom, einer Alkylgruppe mit 1 bis 30 Kohlenstoffatomen, einer Alkoxygruppe mit 1 bis 30 Kohlenstoffatomen, einem Halogen, einer Sulfongruppe, einer Nitrogruppe und einer Cyanogruppe.

2. Lichtempfindliche Klebezusammensetzung nach Anspruch 1, wobei der Anteil der Epoxid-Verbindung (A) 15 Gewichts% oder mehr und 50 Gewichts% oder weniger, basierend auf der Gesamtmenge der Komponenten (A) bis (C) ist.

3. Lichtempfindliche Klebezusammensetzung nach Anspruch 1 oder 2, wobei das lösliche Polyimid (B) einen durch die allgemeine Formel (3) dargestellten Rest eines Säureanhydrids aufweist:

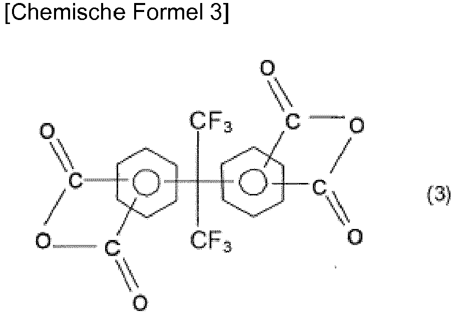

4. Lichtempfindliche Klebezusammensetzung nach einem der Ansprüche 1 bis 3, wobei das lösliche Polyimid (B) ferner einen durch die allgemeine Formel (4) dargestellten Rest eines Diamins aufweist: 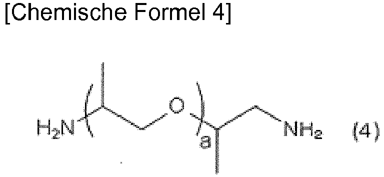 wobei "a" in der allgemeinen Formel (4) einen Bereich zwischen 2 und 10 darstellt.

5. Lichtempfindliche Klebezusammensetzung nach Anspruch 4, wobei der durch die allgemeine Formel (4) dargestellte Rest des Diamins, 50 mol% oder weniger des gesamten Diaminrestes beträgt.

6. Lichtempfindliche Klebefolie, umfassend einen Träger und einen Beschichtungsfilm aus der lichtempfindlichen Klebezusammensetzung nach einem der Ansprüche 1 bis 5, der auf dem Träger gebildet ist.

7. Halbleitervorrichtung, umfassend eine Vielzahl an Substraten oder ein Substrat und andere Elemente, welche durch ein ausgehärtetes Produkt der lichtempfindlichen Klebezusammensetzung nach einem der Ansprüche 1 bis 5 aneinander gebunden sind.

## Revendications

1. Composition adhésive photosensible comprenant :
(A) un composé époxy,
(B) un polyimide soluble,
(C) un composé photopolymérisable, et
(D) un initiateur de photopolymérisation, où
le composé époxy (A) contient un composé époxy représenté par la formule générale (1), et également le polyimide soluble (B) a un résidu de diamine représenté par la formule générale (2) : 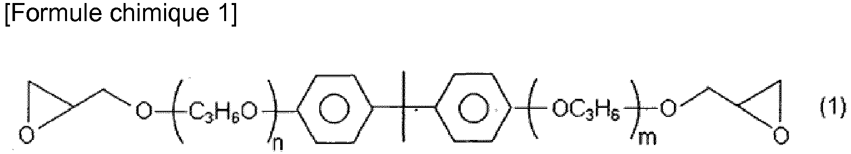 dans laquelle m et n dans la formule générale (1) sont des nombres entiers supérieurs ou égaux à 0, qui satisfont la relation : 1 ≤ m + n ≤ 10 ; et 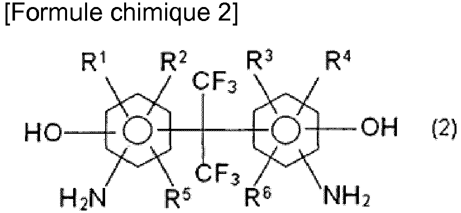 dans laquelle R¹ à R⁸ dans la formule générale (2) peuvent être respectivement identiques ou différents, et choisis dans le groupe constitué d'un atome d'hydrogène, d'un groupe alkyle ayant 1 à 30 atome(s) de carbone, d'un groupe alcoxy ayant 1 à 30 atome(s) de carbone, d'un halogène, d'un groupe sulfone, d'un groupe nitro et d'un groupe cyano.

2. Composition adhésive photosensible selon la revendication 1, dans laquelle la teneur en composé époxy (A) est supérieure ou égale à 15% en poids et inférieure ou égale à 50% en poids par rapport à la quantité totale des composants (A) à (C).

3. Composition adhésive photosensible selon la revendication 1 ou 2, dans laquelle le polyimide soluble (B) a un résidu d'un anhydride acide représenté par la formule générale (3) :

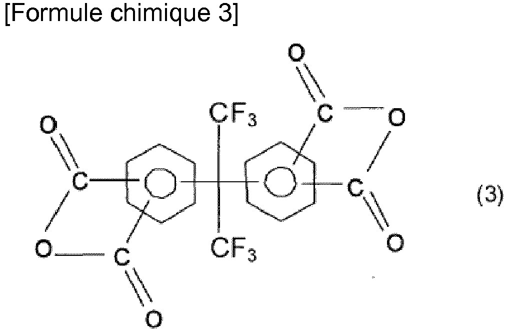

4. Composition adhésive photosensible selon l'une quelconque des revendications 1 à 3, dans laquelle le polyimide soluble (B) a en outre un résidu de diamine représenté par la formule générale (4) : 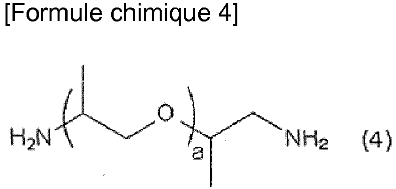 dans laquelle "a" dans la formule générale (4) représente une plage comprise entre 2 et 10.

5. Composition adhésive photosensible selon la revendication 4, dans laquelle le résidu de diamine représenté par la formule générale (4) représente 50% en moles ou moins du résidu de diamine entier.

6. Feuille adhésive photosensible comprenant un support et un film de revêtement de la composition adhésive photosensible selon l'une quelconque des revendications 1 à 5 formé sur le support.

7. Dispositif à semi-conducteur comprenant une pluralité de substrats ou un substrat et d'autres éléments qui sont liés l'un à l'autre par un produit durci de la composition adhésive photosensible selon l'une quelconque des revendications 1 à 5.
